# EUROPEAN PATENT SPECIFICATION

(11) **EP 4 303 919 B1**
(45) Date of publication and mention of the grant of the patent: **05.08.2026**
(21) Application number: 22774081.8
(22) Date of filing: 15.03.2022
(51) Int. Cl.: H10W 70/65, H10W 90/00, G11C 5/04, G11C 5/06, H10W 72/00

(54) **PACKAGE SUBSTRATE, SEMICONDUCTOR DEVICE AND ELECTRONIC APPARATUS**
VERKAPSELUNGSSUBSTRAT, HALBLEITERBAUELEMENT UND ELEKTRONISCHE VORRICHTUNG
SUBSTRAT DE BOÎTIER, DISPOSITIF À SEMI-CONDUCTEUR ET APPAREIL ÉLECTRONIQUE

(30) Priority: 26.03.2021 CN 202110327232
(43) Date of publication of application: 10.01.2024
(60) Divisional application: 25226871.9
(73) Proprietor: Huawei Technologies Co., Ltd., Shenzhen, Guangdong 518129 (CN)
(72) Inventor: PENG, Xiping, Shenzhen, Guangdong 518129 (CN); YUAN, Zhenhua, Shenzhen, Guangdong 518129 (CN)
(74) Representative: Körber, Martin Hans
(86) International application number: PCT/CN2022/080813
(87) International publication number: WO 2022/199420

(56) References cited:
- CN-A- 106 206 515
- CN-A- 107 393 898
- CN-B- 107 393 898
- JP-A- 2016 045 613
- US-A1- 2003 052 417
- US-A1- 2003 052 417
- US-A1- 2017 025 345

## Description

### TECHNICAL FIELD

This application relates to the field of electronic device technologies, and in particular, to a package substrate, a semiconductor device, and an electronic device.

### BACKGROUND

With the development of computer technologies and communications technologies, a rate of data exchange between a processor and a memory chip of some electronic devices such as communications device, server, and computer is continuously improved, which continuously raises requirements for a memory bus bit width, a storage density, and the like, and also poses a corresponding challenge to chip packaging technologies. For pin arrangement of a package substrate of a chip, there are two main requirements: One is to minimize electromagnetic crosstalk between pins, and the other is to minimize the package area of the chip, that is, to implement high-density arrangement of pins. However, increasing the pin arrangement density inevitably causes an increase in electromagnetic crosstalk. In view of this, how to arrange the pins of the package substrate with low crosstalk and high density has become a technical problem needing to be urgently resolved at present.

US 2003/052417 A1, CN 107 393 898 B and JP 2016 045613 A disclose package substrate pattern designs. US 2003/052417 A1 discloses a semiconductor chip, the chip is formed into an equilateral triangular shape or into a shape similar to an equilateral triangular shape. Alternatively, a semiconductor chip is formed into an equilateral triangular shape or into a shape in which equilateral triangles are arranged side by side. CN 107 393 898 B discloses a package substrate, which comprises a substrate and a plurality of solder balls on the substrate, wherein the solder balls form a plurality of unit zones; each of the unit zones includes at least one first solder ball structure; the first solder ball structure includes six first solder balls; the six solder balls are arranged to form an isosceles triangle; and the six first solder balls are respectively arranged at three vertexes of the isosceles triangle and middle points of three sidelines. JP 2016 045613 A discloses a method for designing a semiconductor, the method comprising: calculating a first amount of delay variation due to simultaneous switching noise in output signals output to each of a plurality of connection terminals arranged in the semiconductor package, and a second amount of delay variation due to crosstalk between the output signals; and determining a terminal arrangement of the connection terminals on the basis of the first amount of delay variation and the second amount of delay variation.

### SUMMARY

This application provides a package substrate, a semiconductor device, and an electronic device, to reduce crosstalk between pins of a chip, and reduce a packaging area by increasing an arrangement density of pins, thereby reducing development costs of the semiconductor device.

The invention is defined in the independent claims. Additional features of the invention are provided in the dependent claims. In the following, parts of the description and drawings referring to embodiments which are not covered by the claims are not presented as embodiments of the invention, but as examples useful for understanding the invention.

According to a first aspect, this application provides a package substrate, where the package substrate includes a substrate body and a plurality of unit regions disposed on the substrate body. A unit region may include two first solder ball structures, and each first solder ball structure may include six first solder balls. The six first solder balls may be arranged, with two of them in a row, to form three rows of solder balls that are parallel to each other: a first row of solder balls, a second row of solder balls, and a third row of solder balls. The four first solder balls in the first row of solder balls and the second row of solder balls may be respectively located at four vertices of a parallelogram, and the four first solder balls in the second row of solder balls and the third row of solder balls may be respectively located at four vertices of the other parallelogram. In this case, a connection line between the two first solder balls in the second row of solder balls becomes a common side of the two parallelograms, and the two parallelograms are arranged axisymmetric about the second row of solder balls.

In the foregoing solution, the six first solder balls included in the first solder ball structure in the unit region are arranged in a double-parallelogram manner, which can not only help reduce crosstalk between the first solder balls, but also can increase an arrangement density of the first solder balls, thereby reducing a packaging area and further reducing development costs of a semiconductor device.

During specific arrangement, two first solder ball structures in each unit region may be arranged opposite to each other, and the second rows of solder balls of the two first solder ball structures may be arranged in a collinear manner. In this way, each unit region occupies less space, thereby reducing a packaging area.

In some possible implementation solutions, the six first solder balls in the first solder ball structure may be respectively two differential signal solder balls and four single-ended signal solder balls, where the two differential signal solder balls are a pair. During specific arrangement, the two differential signal solder balls may be located in the second row of solder balls, that is, a side formed by a connection line of the two differential signal solder balls is a common side of the two parallelograms, and the four single-ended signal solder balls are respectively arranged in the first row of solder balls and the third row of solder balls. Based on a symmetric structure of the two parallel quadrilaterals, two single-ended solder balls in the first row and two single-ended solder balls in the third row are symmetrically distributed on two sides of a pair of differential signal solder balls. Because the two signals of the pair of differential signal solder balls have equal amplitudes and opposite phases, impact of the pair of differential signal solder balls on the single-ended signal solder balls can be mutually offset, thereby reducing electromagnetic interference caused by differential signals to single-ended signals.

In some possible implementation solutions, ground solder balls may be arranged around a first solder ball structure to reduce mutual crosstalk between adjacent first solder ball structures.

A plurality of ground solder balls may be arranged around a first solder ball structure, so that return current solder balls may be formed around the first solder ball structure, thereby reducing electromagnetic interference between the first solder ball structure and another first solder ball structure.

During specific arrangement, a quantity of ground solder balls arranged around each first solder ball structure may be 11, and connection lines of the 11 ground solder balls sequentially arranged along a periphery of a first solder ball structure may form a nonagon. In this arrangement manner, a larger quantity of ground solder balls may be arranged around each single-ended signal solder ball, thereby effectively reducing electromagnetic crosstalk between signals.

In some possible implementation solutions, a first solder ball structure may include a first side, a second side, a third side, and a fourth side. The first side is a side that is of the first solder ball structure and that is away from another first solder ball structure in a unit region. The second side is opposite to the first side. The third side and the fourth side are both located between the first side and the second side, and the third side is opposite to the fourth side. On the first side of the first solder ball structure, connection lines of a plurality of ground solder balls may form a sawtooth shape. On the second side of the first solder ball structure, connection lines of a plurality of ground solder balls may form a trapezoid shape. On the third side and the fourth side of the first solder ball structure, connection lines of a plurality of ground solder balls are respectively in a straight-line shape. This arrangement manner can better match an arrangement form of the double parallelograms of the first solder ball structure, so that the 11 ground solder balls may be close to an outer side of single-ended signal solder balls, thereby decreasing an arrangement area of ground solder balls and further reducing a packaging area.

In each unit region, the two first solder ball structures may share a plurality of ground solder balls on their respective second sides. In this way, a quantity of arranged ground solder balls can be reduced without compromising a signal anti-interference capability, thereby decreasing an arrangement area of ground solder balls.

In some possible implementation solutions, two unit regions adjacent in a row direction are staggered along a column direction. The first sides of the two adjacent first solder ball structures that are respectively located in the two adjacent unit regions in the row direction have an overlapping part, and the two unit regions adjacent in the row direction may share a plurality of ground solder balls in the overlapping part. In this way, a quantity of ground solder balls that are arranged can be reduced without compromising the signal anti-interference capability.

In some possible implementation solutions, two unit regions adjacent in a column direction may be symmetrically arranged, and in two symmetric first solder ball structures in the two unit regions adjacent in a column direction, a third side of one first solder ball structure and a fourth side of the other first solder ball structure overlap, and an overlapping side of the two first solder ball structures may share a plurality of ground solder balls. Similarly, this arrangement manner may also reduce a quantity of arranged ground solder balls without compromising the signal anti-interference capability.

According to a second aspect, this application further provides a semiconductor device. The semiconductor device may include a chip and the package substrate in any one of the foregoing possible implementation solutions. The chip is arranged on the package substrate, and signal pins on the chip are electrically connected to a plurality of first solder balls on the package substrate. The arrangement manner of solder balls on the package substrate may not only reduce electromagnetic crosstalk between signals, but increase an arrangement density of solder balls, thereby reducing a packaging area and further reducing development costs of the semiconductor device.

In some possible implementation solutions, a chip may be specifically a central processing unit. The central processing unit is provided with a plurality of memory channels. A memory channel includes a plurality of byte units, and each byte unit corresponds to one unit region. A first solder ball in a unit region may be used to transmit data signals of a corresponding byte unit.

According to a third aspect, this application further provides an electronic device. The electronic device may include a circuit board and the semiconductor device in the foregoing solution. The semiconductor device is disposed on the circuit board, and signal pins configured to connect to the semiconductor device are disposed on the circuit board. In this way, the semiconductor device may be connected to another device by using the signal pins and a trace on the circuit board, thereby implementing a connection between a chip and an external circuit.

### BRIEF DESCRIPTION OF DRAWINGS

FIG. 1 is a schematic diagram of a local structure of an electronic device according to an embodiment of this application;
FIG. 2 is a schematic diagram of a structure of a package substrate according to an embodiment of this application;
FIG. 3 is a schematic diagram of a structure of an arrangement of first solder balls on a package substrate according to an embodiment of this application;
FIG. 4 is a schematic diagram of a structure of another arrangement of solder balls on a package substrate according to an embodiment of this application;
FIG. 5 is a schematic diagram of a structure of an arrangement of unit regions on a package substrate according to an embodiment of this application;
FIG. 6 is a schematic diagram of a hardware architecture of a CPU DDR interface according to an embodiment of this application; and
FIG. 7 is a schematic diagram of a CPU DDR interface according to an embodiment of this application.

Reference numerals:
100: circuit board; 200: semiconductor device; 10: package substrate; 20: chip; 30: heat dissipation substrate; 40: filling adhesive;
11: substrate body; 12: first solder ball structure; 13: first solder ball; 1201: first row of solder balls; 1202: second row of solder balls;
1203: third row of solder balls; 14: unit region; 15: differential signal solder ball;
16, 16a, 16b, 16c, and 16d: single-ended signal solder balls; 17: ground solder ball; 21: CPU; 22: DDR channel;
23: byte unit.

### DESCRIPTION OF EMBODIMENTS

To make the objectives, technical solutions, and advantages of this application clearer, the following further describes this application in detail with reference to the accompanying drawings. It should be noted that, in the description of this application, "at least one" means one or more, and "a plurality of" means two or more. In view of this, in embodiments of the present invention, "a plurality of" may also be understood as "at least two". The term "and/or" describes an association relationship between associated objects and indicates that three relationships may exist. For example, A and/or B may indicate the following three cases: Only A exists, both A and B exist, and only B exists. In addition, the character "/", unless otherwise specified, generally indicates an "or" relationship between the associated objects. In addition, it should be understood that terms such as "first" and "second" in the description of this application are merely used for distinguishing and description, but should not be understood as indicating or implying relative importance, or should not be understood as indicating or implying a sequence.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. The terms "include", "comprise", and "have", and variants thereof all mean "include but are not limited to", unless otherwise specifically emphasized in another manner.

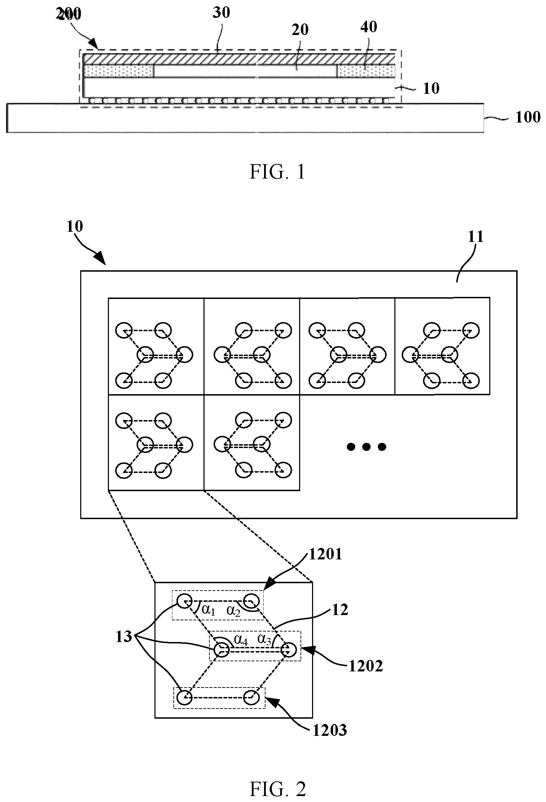

FIG. 1 is a schematic diagram of a partial structure of an electronic device according to an embodiment of this application. The electronic device may be a device in a conventional technology, such as a communications device, a server, a super computer, a router, or a switch. The electronic device may include a circuit board 100 and a semiconductor device 200 disposed on the circuit board 100. The semiconductor device 200 may include a package substrate 10 and a chip 20. The package substrate 10 is used as a carrier of the chip 20, and may be used to provide the chip 20 with various functions, such as electrical connection, protection, support, heat dissipation, and assembly. During packing of the semi-conductor chip, the chip 20 may be placed on the package substrate 10, and all pins on the chip 20 are connected to solder balls or solder pads of the package substrate 10 by using wire bonding or flip chip technologies.

To improve heat dissipation of the chip 20, a heat dissipation substrate 30 may be further disposed on a side that is of the chip 20 and that is away from the package substrate 10. Heat generated when the chip 20 operates may be dissipated to the outside through the lower-side package substrate 10 and the upper-side heat dissipation substrate 30. A filling adhesive 40 may be further disposed between the package substrate 10 and the heat dissipation substrate 30. The filling adhesive 40 may be configured to wrap the chip 20, to reduce adverse impact of external dust, impurities, and the like on performance of the chip 20. In addition, the filling adhesive 40 may be further configured to bond components together, such as the package substrate 10, the heat dissipation substrate 30, and the chip 20, thereby improving structural reliability of the semiconductor device 200.

The semiconductor device 200 may be fastened onto the circuit board 100 through soldering or the like. Signal pins configured to connect to the semiconductor device 200 may be disposed on the circuit board 100. External pins on the semiconductor device 200 may be electrically connected to the signal pins, and then connected to another device by using the signal pins and a trace on the circuit board 100 in sequence, to implement connection between the internal chip 20 and an external circuit.

Quality of a semiconductor packaging technology directly affects performance of the chip 20 and design and manufacturing of the circuit board 100 connected to the chip 20. An important indicator for measuring performance of the semiconductor packaging technology is a ratio of an area of the chip 20 to a packaging area. A smaller value of the ratio indicates a larger packaging area, that is, a larger size of the semiconductor device 200. An increase in a size of the semiconductor device 200 causes a decrease in a manufacturing yield of the semiconductor device and an increase in a soldering risk of the circuit board 100, and further increases manufacturing costs and a reliability risk of product. On the contrary, if the ratio of the area of the chip 20 to the packaging area is closer to 1, it indicates that the packaging area is smaller. In this case, the manufacturing yield of the semiconductor device 200 is higher, and the manufacturing costs may be correspondingly reduced. An arrangement density of pins on the package substrate 10 plays a key role in affecting the packaging area. In order to reduce the packaging area, the arrangement density of the pins needs to be increased. However, on the other side, excessively high pin arrangement density causes electromagnetic crosstalk between pins, thereby affecting performance of the chip.

To resolve this problem, this application provides a package substrate. The package substrate may reduce crosstalk between pins, and may improve pin utilization through proper pin arrangement, thereby reducing the packaging area and reducing development costs of the semiconductor device. The following describes in detail the package substrate provided embodiments of this application with reference to the accompanying drawings.

FIG. 2 is a schematic diagram of a structure of a package substrate according to an embodiment of this application. As shown in FIG. 2, the package substrate 10 may include a substrate body 11 and a plurality of first solder ball structures 12 disposed on the substrate body 11. Each first solder ball structure 12 may include six first solder balls 13. The six first solder balls 13 may be arranged, with two of them in a row, to form a first row of solder balls 1201, a second row of solder balls 1202, and a third row of solder balls 1203. The first row of solder balls 1201, the second row of solder balls 1202, and the third row of solder balls 1203 are parallel to each other. The four first solder balls 13 in the first row of solder balls 1201 and the second row of solder balls 1202 may be respectively located at four vertices of a parallelogram, and the four first solder balls 13 in the second row of solder balls 1202 and the third row of solder balls 1203 may be respectively located at four vertices of the other parallelogram. It may be understood that a connection line between the two first solder balls 13 in the second row of solder balls 1202 is a common side of the two parallelograms. The two parallelograms may be arranged axisymmetric about the common side. In this case, the two parallelograms arranged based on the common side may be spliced into a dovetail. Therefore, in this embodiment of this application, the six first solder balls 13 in the first solder ball structure 12 may also be understood as being separately arranged at six vertices of the dovetail, and the common side is a central axis of the dovetail.

It should be noted that, in FIG. 2 and the following accompanying drawings, dashed connection lines between solder balls are merely used to indicate a position relationship of the solder balls, and do not exist in a specific structure of a package substrate. Therefore, the dashed connection lines do not constitute a limitation on the specific structure of the package substrate.

In specific design, there may be a plurality of choices for inner angles of the two parallelograms. This is not limited in this application. For example, four interior angles α1, α2, α3, and α4 of each of the two parallelograms may be respectively 60°, 120°, 60°, and 120°.

In some embodiments, the package substrate 10 may be a substrate configured to package a semiconductor chip, and pins of the semiconductor chip may be connected to a plurality of first solder balls 13 on the package substrate 10 by using leads. Therefore, the first solder balls 13 of the first solder ball structures 12 may also be understood as pins of the package substrate 10.

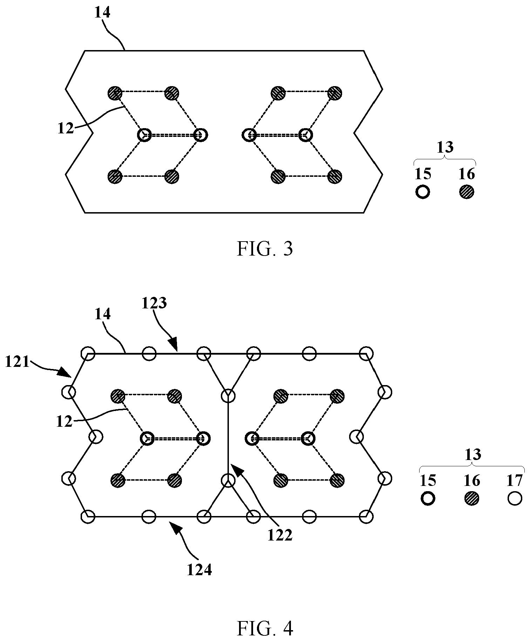

FIG. 3 is a schematic diagram of a structure of arrangement of first solder balls on a package substrate according to an embodiment of this application. As shown in FIG. 3, in this embodiment of this application, two adjacent first solder ball structures 12 may form a unit region 14 in a geometric arrangement shape, and a plurality of unit regions 14 form a pin region of the package substrate. In each unit region 14, two first solder ball structures 12 may be arranged opposite to each other, and central axes of the two first solder ball structures 12 are collinear.

In an example, each unit region 14 may correspond to data signals of a single byte unit, or the first solder balls 13 included in the two first solder ball structures 12 are configured to transmit data signals of a single byte unit. Each byte unit may usually include four differential signals and eight single-ended signals, and the four differential signals may be further divided into two pairs of differential signals. Two signals of each pair of differential signals have equal amplitudes and opposite phases.

The six first solder balls 13 in the first solder ball structure 12 may include two differential signal solder balls 15 and four single-ended signal solder balls 16, and the two differential signal solder balls 15 are a pair of differential signal solder balls 15. It may be understood that, in each unit region 14, two pairs of differential signal solder balls 15 of the two first solder ball structures 12 may correspond to two pairs of differential signals in a single byte unit, and eight single-ended signal solder balls 16 may correspond to eight single-ended signals in a single byte unit.

Still as shown in FIG. 3, in the first solder ball structure 12, the two differential signal solder balls 15 may be arranged on a central axis of a dovetail shape, that is, a side formed by the connection line of the two differential signal solder balls 15 is a common side of the two parallelograms. The four single-ended signal solder balls 16 are respectively arranged at the other four vertices of the dovetail shape. Two single-ended signal solder balls 16 and two differential signal solder balls 15 form a parallelogram, and the other two single-ended signal solder balls 16 and the two differential signal solder balls 15 form the other parallelogram.

Based on a dovetail-shaped symmetric structure, single-ended signal solder balls 16a and 16b in the first solder ball structure 12 are symmetrically distributed on two sides of a pair of differential signal solder balls 15. Because two signals of a pair of differential signals have equal amplitudes and opposite phases, impact of the differential signal solder balls 15 on the single-ended signal solder balls 16a and 16b may be mutually offset, thereby reducing electromagnetic crosstalk caused by differential signals to single-ended signals. Similarly, single-ended signal solder balls 16c and 16d in the first solder ball structure 12 are also symmetrically distributed on two sides of the pair of differential signal solder balls 15. Therefore, impacts of the differential signal solder balls 15 on the single-ended signal solder balls 16c and 16d may also be mutually offset, thereby reducing electromagnetic crosstalk caused by differential signals to single-ended signals.

In addition, it can be learned from FIG. 3 that, in this embodiment of this application, there is only one single-ended signal solder ball 16 adjacent to each single-ended signal solder ball 16, that is, a quantity of single-ended signal solder balls 16 arranged around each single-ended signal solder ball 16 is small, so that electromagnetic crosstalk between single-ended signal solder balls 16 can be reduced.

FIG. 4 is a schematic diagram of a structure of another arrangement of solder balls on a package substrate according to an embodiment of this application. As shown in FIG. 4, in this embodiment of this application, ground solder balls 17 may be further arranged around a first solder ball structure 12, and there may be a plurality of ground solder balls 17, to form return current solder balls around the first solder ball structure 12, thereby reducing electromagnetic interference to other solder balls.

In some embodiments, 11 ground solder balls 17 may be arranged around the first solder ball structure 12. Three ground solder balls 17 are arranged on a first side 121 that is of the first solder ball structure 12 and that is away from another first solder ball structure 12 in a same unit region 14. The three ground solder balls 17 on this side are respectively located at three vertices of an isosceles corner, and two sides of the corner are respectively parallel to the sides that are of two parallelograms and that face the first side 121. Two ground solder balls 17 are arranged on a second side 122 opposite to the first side 121, and a connection line of the two ground solder balls 17 on the side 122 is arranged perpendicular to a central axis of a dovetail shape. A third side 123 and a fourth side 124 adjacent to the first side 121 each are provided with three ground solder balls 17. The three ground solder balls 17 on the third side 123 are arranged in a straight line, which is parallel with the central axis of the dovetail shape. The three ground solder balls 17 on the fourth side 124 are also arranged in a straight line, which is also parallel with the central axis of the dovetail shape.

It may be understood that, among the three ground solder balls 17 on the third side 123, the ground solder ball 17 closest to the first side 121 may also be considered to be located on the first side 121, and among the three ground solder balls on the fourth side 124, the ground solder ball 17 closest to the first side 121 may also be considered to be located on the first side 121. In this way, it may be considered that five ground solder balls 17 are arranged on the first side 121, and connection lines of the five ground solder balls 17 are arranged in a sawtooth shape with four sides. Similarly, among the three ground solder balls 17 on the third side 123, the ground solder ball 17 closest to the second side 122 may also be considered to be located on the second side 122, and among the three ground solder balls 17 on the fourth side 124, the ground solder ball 17 closest to the second side 122 may also be considered to be located on the second side 122. In this way, it may be considered that four ground solder balls 17 are arranged on the second side 122, and connection lines of the four ground solder balls 17 are arranged in an isosceles trapezoid shape. In other words, in this embodiment, connection lines of the 11 ground solder balls arranged around the first solder ball structure 12 present as a nonagonal shape. This arrangement manner can better match a dovetail-shaped arrangement form of the first solder ball structure 12, so that the 11 ground solder balls 17 may be close to outer sides of the single-ended signal solder balls 16, thereby reducing an arrangement area of the ground solder balls 17 and further enabling the package substrate to accommodate more solder balls.

In addition, the ground solder balls 17 are arranged in a nonagonal around the first solder ball structure 12, so that more ground solder balls 17 may be arranged around each single-ended signal solder ball 16. For example, in the embodiment shown in FIG. 3, at least three ground solder balls 17 may be arranged around each single-ended signal solder ball 16, thereby effectively reducing electromagnetic interference between signals.

In each unit region 14, the two first solder ball structures 12 may share ground solder balls 17. For example, the first solder ball structure 12 on the left side and the first solder ball structure 12 on the right side may share two ground solder balls 17 in between them, that is, the two ground solder balls 17 on the second side of the first solder ball structure 12. In this way, a quantity of ground solder balls 17 may be reduced without compromising a signal anti-interference capability, thereby reducing the arrangement area of ground solder balls 17 and manufacturing costs of the package substrate.

During specific arrangement, a spacing between solder balls is not limited in this embodiment of this application, and may be specifically designed according to an actual use requirement. In some embodiments, a spacing between adjacent solder balls may be 0.8 mm to 1.2 mm. For example, a value of the spacing between adjacent solder balls may be 0.8 mm, 0.9 mm, 1 mm, 1.1 mm, 1.2 mm, or the like.

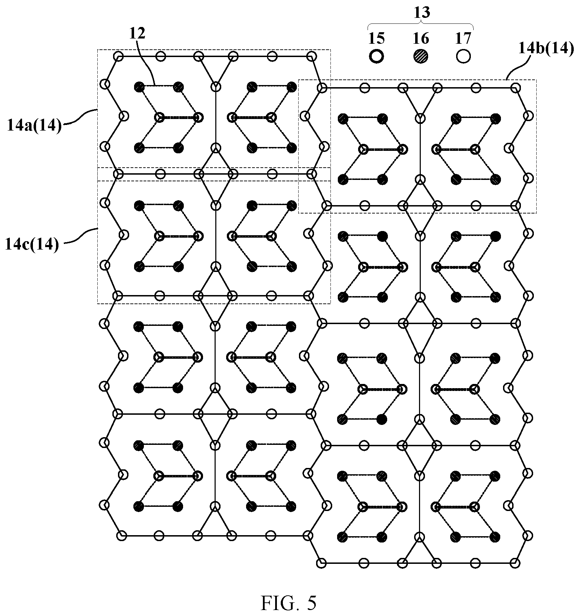

FIG. 5 is a schematic diagram of a structure of an arrangement of unit regions on a package substrate according to an embodiment of this application. With reference to both FIG. 4 and FIG. 5, in this embodiment of this application, unit regions 14 may extend horizontally or vertically to form a pin region of the package substrate. It can be learned from FIG. 5 that both a left side and a right side of a unit region 14 are in a sawtooth shape, and both an upper side and a lower side of the unit region 14 are straight-line sides. In specific design, two unit regions 14 adjacent in a row direction may be staggered in a column direction. For two adjacent first solder ball structures 12 that are located in two unit regions 14 adjacent in a row direction, first sides 121 of the two first solder ball structures 12 have an overlapping part, and the two adjacent unit regions 14 in the row direction may share a plurality of ground solder balls 17 located in the overlapping part. That is, the right sawtooth side of a left unit region 14a may match the left sawtooth side of a right unit region 14b, and a first solder ball structure 12 disposed close to the right side in the left unit region 14a and a first solder ball structure 12 disposed close to the left side in the right unit region 14b may share three ground solder balls 17 in the overlapping part. In this way, an arrangement area of ground solder balls 17 may be reduced, and the left and right unit regions 14 may further share a part of ground solder balls 17, so that a quantity of ground solder balls 17 arranged may be reduced without compromising a signal anti-interference capability.

In addition, two unit regions 14 that are adjacent in a column direction may be symmetrically arranged. For the two symmetric first solder ball structures 12 that are respectively located in the two unit regions 14 that are adjacent in a column direction, a third side 123 of one first solder ball structure 12 overlaps a fourth side 124 of the other first solder ball structure 12, and a plurality of ground solder balls 17 on the overlapping side may be shared. For example, in the unit region 14a and a unit region 14c shown in FIG. 5, the straight-line side of a lower side (a fourth side) of the upper unit region 14a may overlap the straight-line side of an upper side (a third side) of the lower unit region 14c, and the unit region 14a and the unit region 14c may share three ground solder balls 17 on the overlapping side. Similarly, this arrangement manner may not only reduce an arrangement area of ground solder balls 17, but enable part of ground solder balls 17 to be shared by the upper and lower unit regions 14, thereby reducing a quantity of arranged ground solder balls 17 without compromising the signal anti-interference capability.

It should be noted that the package substrate provided in this embodiment of this application may be configured to match a central processing unit (CPU) chip. In other words, the package substrate in this embodiment of this application may be configured to package a CPU. The following describes a specific matching manner between the package substrate and the CPU.

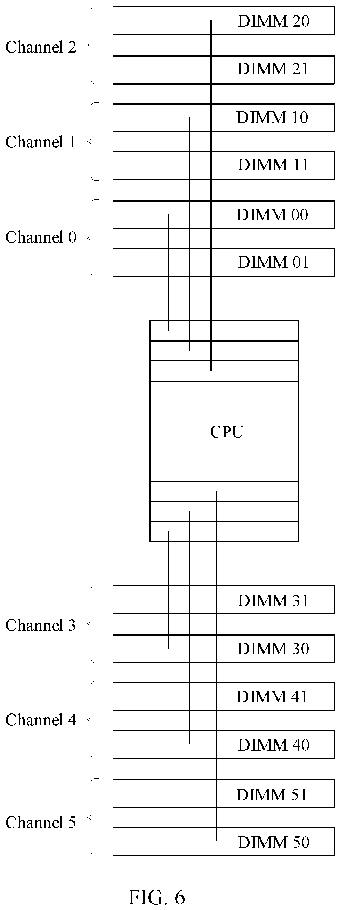

FIG. 6 is a schematic diagram of a hardware architecture of a double data rate synchronous dynamic random access memory (DDR SDRAM) interface of a CPU according to an embodiment of this application. With reference to FIG. 6, usually there are a plurality of DDR channels on the CPU side, and each DDR channel may drive and connect to one or more memory modules, for example, dual in-line memory modules (DIMM). The foregoing channel may be a memory channel configured for the CPU, and a memory bandwidth of a channel is usually 32 bits or 64 bits.

For example, the CPU may include six DDR channels, which are respectively numbered 0, 1, 2, 3, 4, and 5. Channel 0 may be connected to two memory modules DIMM 00 and DIMM 01, channel 1 may be connected to two memory modules DIMM 10 and DIMM 11, channel 2 may be connected to two memory modules DIMM 20 and DIMM 21, channel 3 may be connected to two memory modules DIMM 30 and DIMM 31, channel 4 may be connected to two memory modules DIMM 40 and DIMM 41, and channel 5 may be connected to two memory modules DIMM 50 and DIMM 51. It should be understood that the CPU in this embodiment of this application is not limited to the architecture shown in FIG. 1. A quantity of channels of the CPU and a quantity of memory modules that are correspondingly connected to each channel may be set depending on an actual requirement. Details are not described herein again.

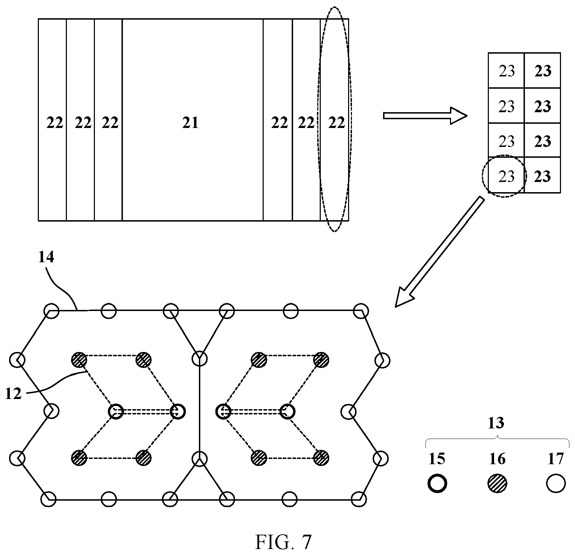

FIG. 7 is a schematic diagram of a DDR interface of a CPU according to an embodiment of this application. As shown in FIG. 6 and FIG. 7, a DDR channel 22 on the CPU 21 side may include a plurality of byte units 23 formed by 8 bits. It may be understood that, when a memory bandwidth of the DDR channel 22 is 32 bits, the DDR channel 22 may include four byte units 23; when the memory bandwidth of the DDR channel 22 is 64 bits, the DDR channel 22 may include eight byte units 23. The embodiment shown in FIG. 6 is described by using an example in which the memory bandwidth of the DDR channel 22 is 64 bits.

In this embodiment, each byte unit 23 may correspond to one of the foregoing unit regions 14, that is, each byte unit 23 may correspond to two first solder ball structures 12. For the DDR channels 22 whose memory bandwidths are 64 bits, each DDR channel 22 corresponds to eight unit regions 14. The eight unit regions 14 may be arranged in a manner of 4x2 (4 means a quantity of rows arranged in the eight unit regions 14, and 2 means a quantity of columns arranged in the eight unit regions 14) shown in FIG. 4 or 2x4, or may be arranged in a same row or a same column. The specific arrangement may be performed based on space division on the package substrate. This is not limited in this application.

As proved by experiments, electromagnetic crosstalk between DDR data signals can be reduced to -33.6 dB by using the package substrate provided in this embodiment of this application to package the CPU and by using a dovetail-shaped pin layout solution of first solder ball structures 12. In addition, if it is assumed that a usable area of a unit region in a conventional trapezoidal arrangement manner is 1, a usable area of the unit region 14 in a dovetail-shaped arrangement manner in this embodiment of this application is approximately 0.95. Therefore, a packaging area can be effectively reduced.

Therefore, the dovetail-shaped pin layout solution used on the package substrate provided in this embodiment of this application may not only reduce electromagnetic crosstalk between DDR data signals and enable a CPU to support a higher DDR running rate, but increase utilization of pins on the package substrate, thereby effectively reducing a packaging area and helping reduce development costs of a semiconductor device.

The foregoing descriptions are merely specific implementation of this application, but are not intended to limit the protection scope of this application. Any variation or replacement readily figured out by a person skilled in the art within the technical scope disclosed in this application should fall within the protection scope of this application. Therefore, the protection scope of this application shall be subject to the protection scope of the claims.

## Claims

1. A semiconductor device (200), comprising a chip (20) and a package substrate (10), wherein the chip (20) is disposed on the package substrate (10), and the package substrate (10) comprises a substrate body (11) and a plurality of unit regions (14) arranged on the substrate body (11), wherein
a unit region (14) of the unit regions (14) comprises two first pin structures (13), one of the two first pin structures (12) comprises six first pins (13), the six first pins (13) are arranged, with two of them in a row, to form three parallel rows of two pins: a first row of pins (1201), a second row of pins (1202), and a third row of pins (1203), four of the first pins in the first row of pins (1201) and the second row of pins (1202) are respectively located at four vertices of a parallelogram, the four of the first pins in the second row of pins (1202) and a third row of pins (1203) are respectively located at four vertices of another parallelogram, and two parallelograms are arranged axisymmetric about the second row of pins (1202), wherein the two first pin structures (12) are arranged in a row direction of the second row of pins (1202), and the two first pin structures (12) are axisymmetric and adjacent to each other; and
the two first pins in the second row of pins (1202) are differential signal pins, and the two first pins in the first row of pins (1201) and the two pins in the third row of pins (1203) are single-ended signal pins ;and
wherein in the unit region (14), the two first pin structures (12) are arranged in the row direction of the second row of pins (1202), the two first pin structures (12) are axisymmetric, and the distance between the first rows of pins (1201) in the two first pin structures (12) is greater than a distance between the second rows of pins (1202) in the two first pin structures (13);
the first pin structure (12) comprises a first side (121), a second side (122), a third side (123), and a fourth side (124), the first side (121) is a side that is of the first pin structure (12) and that is away from the other first pin structure in the same unit region (14), the second side (122) is opposite to the first side (121), the third side (123) and the fourth side (124) are both located between the first side (121) and the second side (122), and the third side (123) is opposite to the fourth side (124); and
ground pins are arranged around the first pin structure (12), and a quantity of the ground pins arranged around the first pin structure is 11, and connection lines of the 11 ground pins sequentially spaced and arranged along a periphery of the first pin structure form a nonagon,
wherein
three ground pins are arranged on the first side (121), three ground pins are respectively located at three vertices of an isosceles triangle, two legs of the isosceles triangle are respectively parallel to sides that are of the two parallelograms of the first pin structure (12) and that face the first side (121), two ground pins are arranged on the second side (122), a connection line of the two ground pins is orthogonal to the row direction of the second row of pins (1202), three ground pins are arranged on each of the third side (123) and the fourth side (124), and the three ground pins on the same side are sequentially spaced and arranged in the row direction of the second row of pins (1202).

2. The semiconductor device according to claim 1, wherein in the unit region, a distance between the first rows of pins in the two first pin structures is greater than a distance between the second rows of pins in the two first pin structures.

3. The semiconductor device according to claim 2, wherein in the unit region, the two first pin structures share the two ground pins on the second side.

4. The semiconductor device according to claim 2, wherein the first row of pins, the second row of pins, and the third row of pins are sequentially arranged in a column direction, two adjacent unit regions in the row direction of the second row of pins are staggered in the column direction, and the two adjacent unit regions in the row direction share some of the ground pins.

5. The semiconductor device according to any one of claims 2 to 4, wherein the first row of pins, the second row of pins, and the third row of pins are sequentially arranged in the column direction, two adjacent unit regions in the column direction are symmetrically arranged, and the two adjacent unit regions in the column direction share some of the ground pins.

6. The semiconductor device according to any one of claims 1 to 5, wherein in a basic graphics unit, a first pin and connection lines of two adjacent first pins form an isosceles triangle, the first pin is one of the pins in the first row of pins (1201) located near the first side (121).

7. The semiconductor device according to any one of claims 1 to 6, wherein in a basic graphics unit, a first pin and connection lines of two adjacent pins form an isosceles triangle, the first pin is one of the pins in the third row of pins (1203) located near the first side (121).

8. The semiconductor device according to any one of claims 1 to 7, wherein the chip is a central processing unit, the central processing unit is provided with a plurality of memory channels, the memory channel comprises a plurality of byte units, each byte unit corresponds to one unit region, and the single-ended signal pins in the unit region are configured to transmit data signals of the corresponding byte unit.

9. An electronic device, comprising a circuit board and the semiconductor device according to any one of claims 1 to 8, wherein the semiconductor device is disposed on the circuit board, signal pins are disposed on the circuit board, and the signal pins are electrically connected to the semiconductor device.

## Patentansprüche

1. Halbleitervorrichtung (200), umfassend einen Chip (20) und ein Gehäusesubstrat (10), wobei der Chip (20) auf dem Gehäusesubstrat (10) vorgesehen ist und das Gehäusesubstrat (10) einen Substratkörper (11) und eine Vielzahl von Einheitsbereichen (14) umfasst, die auf dem Substratkörper (11) angeordnet sind, wobei
ein Einheitsbereich (14) der Einheitsbereiche (14) zwei erste Pinstrukturen (13) umfasst, eine der zwei ersten Pinstrukturen (12) sechs erste Pins (13) umfasst, die sechs ersten Pins (13), jeweils zwei von ihnen in einer Reihe, so angeordnet sind, dass sie drei parallele Reihen aus je zwei Pins bilden: eine erste Pinreihe (1201), eine zweite Pinreihe (1202) und eine dritte Pinreihe (1203), vier der ersten Pins in der ersten Pinreihe (1201) und der zweiten Pinreihe (1202) sich jeweils an vier Eckpunkten eines Parallelogramms befinden, die vier der ersten Pins in der zweiten Pinreihe (1202) und einer dritten Pinreihe (1203) sich jeweils an vier Eckpunkten eines anderen Parallelogramms befinden und zwei Parallelogramme achsensymmetrisch um die zweite Pinreihe (1202) angeordnet sind, wobei die zwei ersten Pinstrukturen (12) in einer Reihenrichtung der zweiten Pinreihe (1202) angeordnet sind und die zwei ersten Pinstrukturen (12) achsensymmetrisch sind und nebeneinander liegen; und
die zwei ersten Pins in der zweiten Pinreihe (1202) Differenzsignalpins sind und die zwei ersten Pins in der ersten Pinreihe (1201) und die zwei Pins in der dritten Pinreihe (1203) unsymmetrische Signalpins sind; und
wobei in dem Einheitsbereich (14) die zwei ersten Pinstrukturen (12) in der Reihenrichtung der zweiten Pinreihe (1202) angeordnet sind, die zwei ersten Pinstrukturen (12) achsensymmetrisch sind und der Abstand zwischen den ersten Pinreihen (1201) in den zwei ersten Pinstrukturen (12) größer ist als ein Abstand zwischen den zweiten Pinreihen (1202) in den zwei ersten Pinstrukturen (13);
die erste Pinstruktur (12) eine erste Seite (121), eine zweite Seite (122), eine dritte Seite (123) und eine vierte Seite (124) umfasst, wobei die erste Seite (121) eine Seite ist, die zu der ersten Pinstruktur (12) gehört und die von der anderen ersten Pinstruktur in demselben Einheitsbereich (14) abgewandt ist, die zweite Seite (122) der ersten Seite (121) gegenüberliegt, die dritte Seite (123) und die vierte Seite (124) beide zwischen der ersten Seite (121) und der zweiten Seite (122) liegen und die dritte Seite (123) der vierten Seite (124) gegenüberliegt; und Erdungspins um die erste Pinstruktur (12) herum angeordnet sind und eine Anzahl der um die erste Pinstruktur herum angeordneten Erdungspins 11 beträgt und Verbindungsleitungen der 11 Erdungspins, die nacheinander beabstandet und entlang eines Umfangs der ersten Pinstruktur angeordnet sind, ein Neuneck bilden,
wobei
drei Erdungspins auf der ersten Seite (121) angeordnet sind, drei Erdungspins sich jeweils an drei Eckpunkten eines gleichschenkligen Dreiecks befinden, zwei Schenkel des gleichschenkligen Dreiecks jeweils parallel zu Seiten, die zu den zwei Parallelogrammen der ersten Pinstruktur (12) gehören und die der ersten Seite (121) zugewandt sind, verlaufen, zwei Erdungspins auf der zweiten Seite (122) angeordnet sind, eine Verbindungslinie der zwei Erdungspins orthogonal zu der Reihenrichtung der zweiten Pinreihe (1202) ist, drei Erdungspins jeweils auf der dritten Seite (123) und der vierten Seite (124) angeordnet sind und die drei Erdungspins auf derselben Seite nacheinander beabstandet und in der Reihenrichtung der zweiten Pinreihe (1202) angeordnet sind.

2. Halbleitervorrichtung nach Anspruch 1, wobei in dem Einheitsbereich ein Abstand zwischen den ersten Pinreihen in den zwei ersten Pinstrukturen größer ist als ein Abstand zwischen den zweiten Pinreihen in den zwei ersten Pinstrukturen.

3. Halbleitervorrichtung nach Anspruch 2, wobei in dem Einheitsbereich die zwei ersten Pinstrukturen die zwei Erdungspins auf der zweiten Seite gemeinsam nutzen.

4. Halbleitervorrichtung nach Anspruch 2, wobei die erste Pinreihe, die zweite Pinreihe und die dritte Pinreihe in einer Spaltenrichtung nacheinander angeordnet sind, zwei benachbarte Einheitsbereiche in der Reihenrichtung der zweiten Pinreihe in der Spaltenrichtung versetzt sind und die zwei benachbarten Einheitsbereiche in der Reihenrichtung einige der Erdungspins gemeinsam nutzen.

5. Halbleitervorrichtung nach einem der Ansprüche 2 bis 4, wobei die erste Pinreihe, die zweite Pinreihe und die dritte Pinreihe in der Spaltenrichtung nacheinander angeordnet sind, zwei benachbarte Einheitsbereiche in der Spaltenrichtung symmetrisch angeordnet sind und die zwei benachbarten Einheitsbereiche in der Spaltenrichtung einige der Erdungspins gemeinsam nutzen.

6. Halbleitervorrichtung nach einem der Ansprüche 1 bis 5, wobei in einer grundlegenden Grafikeinheit ein erster Pin und Verbindungslinien von zwei benachbarten ersten Pins ein gleichschenkliges Dreieck bilden und der erste Pin einer der Pins in der ersten Pinreihe (1201) ist, die sich in der Nähe der ersten Seite (121) befindet.

7. Halbleitervorrichtung nach einem der Ansprüche 1 bis 6, wobei in einer grundlegenden Grafikeinheit ein erster Pin und Verbindungslinien von zwei benachbarten ersten Pins ein gleichschenkliges Dreieck bilden und der erste Pin einer der Pins in der dritten Pinreihe (1203) ist, die sich in der Nähe der ersten Seite (121) befindet.

8. Halbleitervorrichtung nach einem der Ansprüche 1 bis 7, wobei der Chip eine zentrale Verarbeitungseinheit ist, die zentrale Verarbeitungseinheit mit einer Vielzahl von Speicherkanälen bereitgestellt ist, der Speicherkanal eine Vielzahl von Byteeinheiten umfasst, jede Byteeinheit einem Einheitsbereich entspricht und die unsymmetrischen Signalpins in dem Einheitsbereich dazu konfiguriert sind, Datensignale der entsprechenden Byteeinheit zu übertragen.

9. Elektronische Vorrichtung, umfassend eine Leiterplatte und die Halbleitervorrichtung nach einem der Ansprüche 1 bis 8, wobei die Halbleitervorrichtung auf der Leiterplatte vorgesehen ist, Signalpins auf der Leiterplatte vorgesehen sind und die Signalpins elektrisch mit der Halbleitervorrichtung verbunden sind.

## Revendications

1. Dispositif à semi-conducteur (200), comprenant une puce (20) et un substrat de boîtier (10), dans lequel la puce (20) est disposée sur le substrat de boîtier (10), et le substrat de boîtier (10) comprend un corps de substrat (11) et une pluralité de régions unitaires (14) disposées sur le corps de substrat (11), dans lequel
une région unitaire (14) des régions unitaires (14) comprend deux premières structures de broches (13), l'une des deux premières structures de broches (12) comprend six premières broches (13), les six premières broches (13) sont disposées, deux d'entre elles dans une rangée, pour former trois rangées parallèles de deux broches : une première rangée de broches (1201), une deuxième rangée de broches (1202) et une troisième rangée de broches (1203), quatre des premières broches dans la première rangée de broches (1201) et la deuxième rangée de broches (1202) sont respectivement situées à quatre sommets d'un parallélogramme, les quatre des premières broches dans la deuxième rangée de broches (1202) et une troisième rangée de broches (1203) sont respectivement situées à quatre sommets d'un autre parallélogramme, et deux parallélogrammes sont disposés axisymétriquement autour de la deuxième rangée de broches (1202), dans lequel les deux premières structures de broches (12) sont disposées dans une direction de rangée de la deuxième rangée de broches (1202), et les deux premières structures de broches (12) sont axisymétriques et adjacentes l'une à l'autre ; et
les deux premières broches dans la deuxième rangée de broches (1202) sont des broches de signal différentiel, et les deux premières broches dans la première rangée de broches (1201) et les deux broches dans la troisième rangée de broches (1203) sont des broches de signal à extrémité unique ; et
dans lequel dans la région unitaire (14), les deux premières structures de broches (12) sont disposées dans la direction de rangée de la deuxième rangée de broches (1202), les deux premières structures de broches (12) sont axisymétriques, et la distance entre les premières rangées de broches (1201) dans les deux premières structures de broches (12) est supérieure à une distance entre les deuxièmes rangées de broches (1202) dans les deux premières structures de broches (13) ;
la première structure de broche (12) comprend un premier côté (121), un deuxième côté (122), un troisième côté (123) et un quatrième côté (124), le premier côté (121) est un côté qui est de la première structure de broche (12) et qui est éloigné de l'autre première structure de broche dans la même région unitaire (14), le deuxième côté (122) est opposé au premier côté (121), le troisième côté (123) et le quatrième côté (124) sont tous deux situés entre le premier côté (121) et le deuxième côté (122), et le troisième côté (123) est opposé au quatrième côté (124) ; et
des broches de masse sont disposées autour de la première structure de broche (12), et une quantité des broches de masse disposées autour de la première structure de broche est de 11, et des lignes de connexion des 11 broches de masse espacées séquentiellement et disposées le long d'une périphérie de la première structure de broche forment un nonagone,
dans lequel
trois broches de masse sont disposées sur le premier côté (121), trois broches de masse sont respectivement situées à trois sommets d'un triangle isocèle, deux côtés du triangle isocèle sont respectivement parallèles aux côtés qui sont des deux parallélogrammes de la première structure de broche (12) et qui font face au premier côté (121), deux broches de masse sont disposées sur le deuxième côté (122), une ligne de connexion des deux broches de masse est orthogonale à la direction de rangée de la deuxième rangée de broches (1202), trois broches de masse sont disposées sur chacun du troisième côté (123) et du quatrième côté (124), et les trois broches de masse sur le même côté sont espacées séquentiellement et disposées dans la direction de rangée de la deuxième rangée de broches (1202).

2. Dispositif à semi-conducteur selon la revendication 1, dans lequel, dans la région unitaire, une distance entre les premières rangées de broches dans les deux premières structures de broches est supérieure à une distance entre les deuxièmes rangées de broches dans les deux premières structures de broches.

3. Dispositif à semi-conducteur selon la revendication 2, dans lequel dans la région unitaire, les deux premières structures de broches partagent les deux broches de masse sur le deuxième côté.

4. Dispositif à semi-conducteur selon la revendication 2, dans lequel la première rangée de broches, la deuxième rangée de broches et la troisième rangée de broches sont disposées séquentiellement dans une direction de colonne, deux régions unitaires adjacentes dans la direction de rangée de la deuxième rangée de broches sont décalées dans la direction de colonne, et les deux régions unitaires adjacentes dans la direction de rangée partagent certaines des broches de masse.

5. Dispositif à semi-conducteur selon l'une quelconque des revendications 2 à 4, dans lequel la première rangée de broches, la deuxième rangée de broches et la troisième rangée de broches sont disposées séquentiellement dans la direction de colonne, deux régions unitaires adjacentes dans la direction de colonne sont disposées symétriquement, et les deux régions unitaires adjacentes dans la direction de colonne partagent certaines des broches de masse.

6. Dispositif à semi-conducteur selon l'une quelconque des revendications 1 à 5, dans lequel, dans une unité graphique de base, une première broche et des lignes de connexion de deux premières broches adjacentes forment un triangle isocèle, la première broche est l'une des broches dans la première rangée de broches (1201) située à proximité du premier côté (121).

7. Dispositif à semi-conducteur selon l'une quelconque des revendications 1 à 6, dans lequel, dans une unité graphique de base, une première broche et des lignes de connexion de deux broches adjacentes forment un triangle isocèle, la première broche est l'une des broches dans la troisième rangée de broches (1203) située à proximité du premier côté (121).

8. Dispositif à semi-conducteur selon l'une quelconque des revendications 1 à 7, dans lequel la puce est une unité centrale de traitement, l'unité centrale de traitement est pourvue d'une pluralité de canaux mémoire, le canal mémoire comprend une pluralité d'unités d'octet, chaque unité d'octet correspond à une région d'unité, et les broches de signal à extrémité unique dans la région d'unité sont configurées pour transmettre des signaux de données de l'unité d'octet correspondante.

9. Dispositif électronique, comprenant une carte de circuit imprimé et le dispositif à semi-conducteur selon l'une quelconque des revendications 1 à 8, dans lequel le dispositif à semi-conducteur est disposé sur la carte de circuit imprimé, des broches de signal sont disposées sur la carte de circuit imprimé, et les broches de signal sont connectées électriquement au dispositif à semi-conducteur.
